Europäisches Patentamt

European Patent Office

Office européen des brevets

(19)

(11) Veröffentlichungsnummer: **0 144 876**
**B1**

(12) **EUROPÄISCHE PATENTSCHRIFT**

(45) Veröffentlichungstag der Patentschrift:
**09.03.88**

(21) Anmeldenummer: **84114203.7**

(22) Anmeldetag: **24.11.84**

(51) Int. Cl.⁴: **H 01 L 29/743,** H 01 L 29/91,
H 01 L 29/10

(54) Halbleiterbauelement.

(30) Priorität: **07.12.83 CH 6544/83**

(43) Veröffentlichungstag der Anmeldung:
**19.06.85 Patentblatt 85/25**

(45) Bekanntmachung des Hinweises auf die Patenterteilung:
**09.03.88 Patentblatt 88/10**

(84) Benannte Vertragsstaaten:
**CH DE FR GB IT LI NL SE**

(56) Entgegenhaltungen:
**EP - A - 0 029 932**
**EP - A - 0 039 509**
**EP - A - 0 074 133**
**FR - A - 2 324 125**
**FR - A - 2 356 276**
**GB - A - 2 045 000**
**US - A - 4 236 169**
**US - A - 4 305 084**

**IEE PROCEEDINGS, Band 129, Teil 1, Nr. 5, Oktober 1982, Seiten 173-179, Old Woking, Surrey, GB; B. JAYANT BALIGA: "High-voltage device termination techniques. A comparative review"**

(73) Patentinhaber: **BBC Brown Boveri AG, CH-5401 Baden (CH)**

(72) Erfinder: **Roggwiller, Peter, Dr., Püntstrasse 16, CH-8173 Riedt-Neerach (CH)**
Erfinder: **Sittig, Roland, Dr., Rinikerstrasse 102, CH-5222 Umiken (CH)**

## Beschreibung

Die Erfindung betrifft ein Halbleiterbauelement nach dem Oberbegriff des Patentanspruchs 1.

Ein solches Halbleiterbauelement ist bekannt aus Proc. of the 29th Electronic Comp. Conf. (Cherry Hill, NJ, USA; 14. bis 16. Mai 1979) Seiten 75 bis 79. Dort wird ein asymmetrischer Thyristor beschrieben mit einer $p^+n^+npn^+$-Struktur. Zwischen der $p^+$-Schicht und der p-Schicht sind eine dicke niedrigdotierte n-Schicht und eine dünne hochdotierte $n^+$-Schicht vorgesehen, wobei die letztere als sogenannte «Stoppschicht» dient. Sie begrenzt die Ausdehnung der Raumladungszone. Auf diese Art ergibt sich im Bauelement eine p-i-n-Struktur. Der Rand des Bauelementes ist leicht positiv angeschrägt. Eine zweite, stärker positive Anschrägung des Randes ist im Bereich der p-Schicht vorgesehen. Diese Anschrägungen sollen einen Spannungsdruchbruch im Randbereich vermeiden, so dass höhere Sperrspannungen an das Bauelement angelegt werden können. Die Winkel sind anhand des Dotierungsprofils bestimmt. Sie erfordern eine sorgfältige mechanische Randbearbeitung und führen zu einem relativ grossen Verlust der effektiv nutzbaren Fäche.

Es ist weiterhin aus der FR-A-2 324 125 eine Thyristorstruktur mit n-Stoppschicht gemäss dem Oberbegriff des Anspruchs 1 bekannt, die im Randbereich eine Abschrägung aufweist, die als Ausnehmung angesehen werden kann. Auch hier ist die Bearbeitung des Substrats im Randbereich aufwendig, weil beim entsprechenden Dotierungsprofil der n-Stoppschicht keine besonderen Vorkehrungen getroffen werden.

Der vorliegenden Erfindung, wie sie in den Patentansprüchen gekennzeichnet ist, liegt die Aufgabe zugrunde, ein Halbleiterbauelement mit hoher Sperrspannung anzugeben, das geringere Verluste an wirksamer Nutzfläche aufweist und eine einfachere Herstellung ermöglicht.

Ein wesentlicher Vorteil der Erfindung besteht darin, dass die Winkel der Anschrägungen für die Randkonturierung der oben erwähnten Halbleiterbauelemente nicht kritisch sind. Dadurch kann statt einer mechanischen Randbearbeitung ein üblicher Ätzprozess für die Konturierung verwendet werden. Wichtig ist die Zahl der dotierten Atome in der Stoppschicht, die durch Ionenimplantion problemlos zu erreichen ist. Die Erfindung ist anwendbar bei allen Halbleiterbauelementen, die nur in einer Polarität hohe Sperrspannungen aufnehmen müssen, insbesondere Dioden, rückwärtsleitende Thyristoren und asymmetrische Thyristoren.

Die Erfindung wird nachstehend anhand von in der Zeichnung dargestellten Ausführungsbeispielen näher erläutert. Dabei zeigt:

Fig. 1a einen Teil eines Querschnittes durch eine erste Diodenstruktur nach der Erfindung,

Fig. 1b Feldstärke und Dotierung längs der Linie A–A von Fig. 1a,

Fig. 2a einen Teil eines Querschnittes durch eine zweite Diodenstruktur nach der Erfindung,

Fig. 2b Feldstärke und Dotierung längs der Linien X–X und Y–Y von Fig. 2a,

Fig. 3 einen Teil eines Querschnittes durch eine erste Thyristorstruktur nach der Erfindung, und

Fig. 4 einen Teil eines Querschnittes durch eine zweite Thyristorstruktur nach der Erfindung.

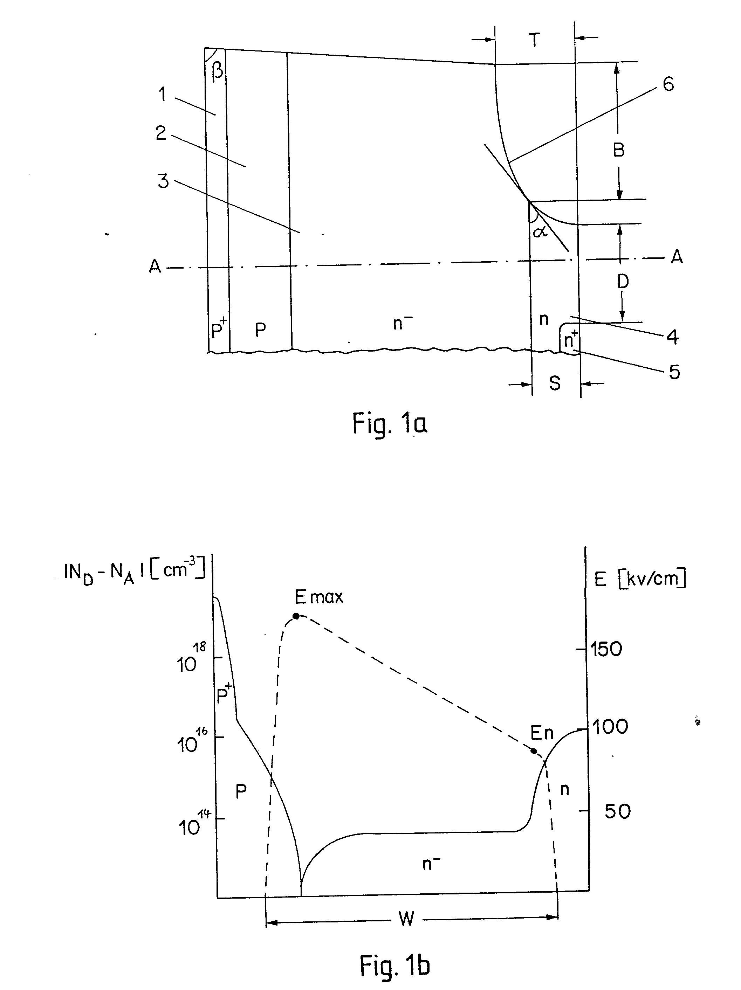

In Fig. 1a ist der Schichtenaufbau eines erfindungsgemässen scheibenförmigen Bauelementes mit Diodenstruktur mit zwei im wesentlichen parallel zueinander verlaufenden endseitigen Oberflächen dargestellt, das aus einem anodenseitigen hochdotierten $p^+$-Emitter 1, einem niedriger dotierten p-Gebiet 2, einer niedrigdotierten $n^-$-Zone 3, einer höher dotierten n-Schicht 4 (Stoppschicht) und einem kathodenseitigen hochdotierten $n^+$-Emitter 5 besteht. Auf der Seite des $n^+$-Emitters 5 ist am Rande des Bauelementes eine Ausnehmung 6 im Bereich der $n^-$-Zone 3 und der n-Schicht 4 vorgesehen, die durch eine Tiefe T, eine Breite B und einen Winkel α charakterisiert ist. Dabei ist T die maximale Tiefe von der Ebene der kathodenseitigen Oberfläche des Bauelementes, B die Breite, in der die Stoppschicht 4 vollständig abgetragen ist, vom Rand des Bauelementes bis zu dem $n^-n$-Übergang, und α der Winkel zwischen der Tangente an dem $n^-n$-Übergang und der kathodenseitigen Oberfläche des Bauelementes. Der Rand des Bauelementes bildet am pn-Übergang einen Winkel β zur Oberfläche des $p^+$-Emitters 1 mit $30° \leqslant β \leqslant 120°$. Dieser Winkel β ist üblicherweise etwa 90°. Mit D ist die Breite bezeichnet, in der vom $n^+$-Emitter 5 aus die n-Schicht 4 – gemessen an der Oberfläche des Bauelements – vollständig erhalten bleibt. Die n-Schicht 4, die sogenannte Stoppschicht, hat eine Dicke S, die gemessen wird von der kathodenseitigen Oberfläche der n-Schicht 4 bis zur angrenzenden $n^-$-Zone 3, d.h. bis zu dem Punkt, bei dem die n-Konzentration um 10% höher ist als die $n^-$-Konzentration der $n^-$-Zone 3.

Fig. 1b zeigt ausgezogen den Dotierungsverlauf und gestrichelt die elektrische Feldstärke bei maximal an dem Bauelement anliegender Spannung längs des Schnittes A–A in Fig. 1a. Die Feldstärke E ist auf der rechten Ordinate aufgetragen, die Donatorkonzentration $N_D$ und die Akzeptorkonzentration $N_A$ auf der linken Ordinate. Die Abszisse bezieht sich auf die Breite des Bauelementes und stimmt mit Fig. 1a überein. Die Raumladungszone erstreckt sich über eine Breite W. Diese Breite W ist definiert durch die Breite der niedrigdotierten Basiszone des Bauelementes, umfasst also die Breite der $n^-$-Zone 3 und des niedrigdotierten Teils des p-Gebietes 2, und liegt zwischen 50 µm und 800 µm. Für $D > 2W$ tritt die maximale Feldstärke $E_{max}$ weit entfernt von der Oberfläche am pn-Übergang zwischen dem p-Gebiet 2 und der $n^-$-Zone 3 auf und beträgt $1{,}7 \cdot 10^5$ V/cm bis $2{,}2 \cdot 10^5$ V/cm bei hochsperrenden Bauelementen. Die Feldstärke am Rand der Stoppschicht 4 wird mit $E_n$ bezeichnet und beträgt bei der üblichen Dimensionierung $E_n = 0{,}5\ E_{max} \approx 10^5$ V/cm. Die Dicke S der Stoppschicht 4 und ihre Donatordotierung sind so gewählt, dass gilt:

$$\frac{e}{\varepsilon} \int_0^S N_D(x)\, dx = k\, E_n \qquad (1)$$

mit

e = Elementarladung,

$\varepsilon$ = Dielektrizitätskonstante des Halbleiter-werkstoffes (Silizium) = $\varepsilon_0 \cdot \varepsilon_r$, $\varepsilon_0$ = absolute DK, $\varepsilon_r$ = relative DK

$N_D(x)$ = Donatorenkonzentration der Stopp-schicht 4 in cm$^{-3}$ und

k = Konstante, die im Bereich $0{,}8 \leqslant k \leqslant 1{,}0$ gewählt ist.

Das Integral ist über die ganze Dicke der n-Schicht 4 (ausserhalb des n$^+$-Emitters 5) zu erstrecken. Die maximale Feldstärke $E_{max}$ am pn-Übergang zwischen dem p-Gebiet 2 und der n$^-$-Zone 3 ist von der Dimensionierung und Dotierung des Bauelementes vorgegeben und wird bei der Durchbruchspannung bestimmt (vgl. z.B. Sze, Phys. of Semicond., Wiley Int. N.Y. (1969), Kapitel III). Das Gleiche gilt für die Feldstärke $E_n$ am Rand der Stoppschicht 4. Insbesondere gilt beim beschriebenen Bauelement für die Durchbruchspannung $V_B = 0{,}7\, E_{max}\, W$. Für $E_n = 10^5$ V/cm erhält man z.B. eine Gesamtmenge der Dotierungsatome in der Stoppschicht 4 im Bereich von $5{,}0 \cdot 10^{11}$ Atome/cm$^2$ bis $6{,}25 \cdot 10^{11}$ Atome/cm$^2$. Die Distanzen D und B sind vorzugsweise so gewählt, dass $D \geqslant W$ und $B \geqslant W$ sind. Die Tiefe T ist grösser als S; vorzugsweise wird $S < T < \frac{W}{2}$ gewählt. Die Dicke S der Stoppschicht 4 ist bei defektfreiem Material unkritisch und ist etwa doppelt so gross wie die Eindringtiefe des n$^+$-Emitters 5, d.h. zwischen 10 µm und 30 µm. Es ha sich ergeben, dass unter den vorgenannten Bedingungen die Winkel $\alpha$ und $\beta$ in weiten Bereichen variiert werden können ohne das Sperrvermögen des Bauelementes zu verringern. Vor allem haben sich die folgenden Bereiche bewährt:

$$10° < \alpha < 60° \text{ und } 30° \leqslant \beta \leqslant 120° \qquad (2)$$

Weil die Konturierung des Randes des erfindungsgemässen Bauelementes weitgehend unkritisch ist, können nunmehr die üblichen Ätzprozesse dazu verwendet werden. Die Dotierstoffmenge der Stoppschicht 4 sollte auf ± 100% genau eingehalten werden, was mit der üblichen Ionenimplantionstechnik kein Problem ist. Durch die oben erwähnten Massnahmen wird erreicht, dass der Flächenverlust auf eine Randzone von ungefähr $B + D \approx 2W$ begrenzt ist.

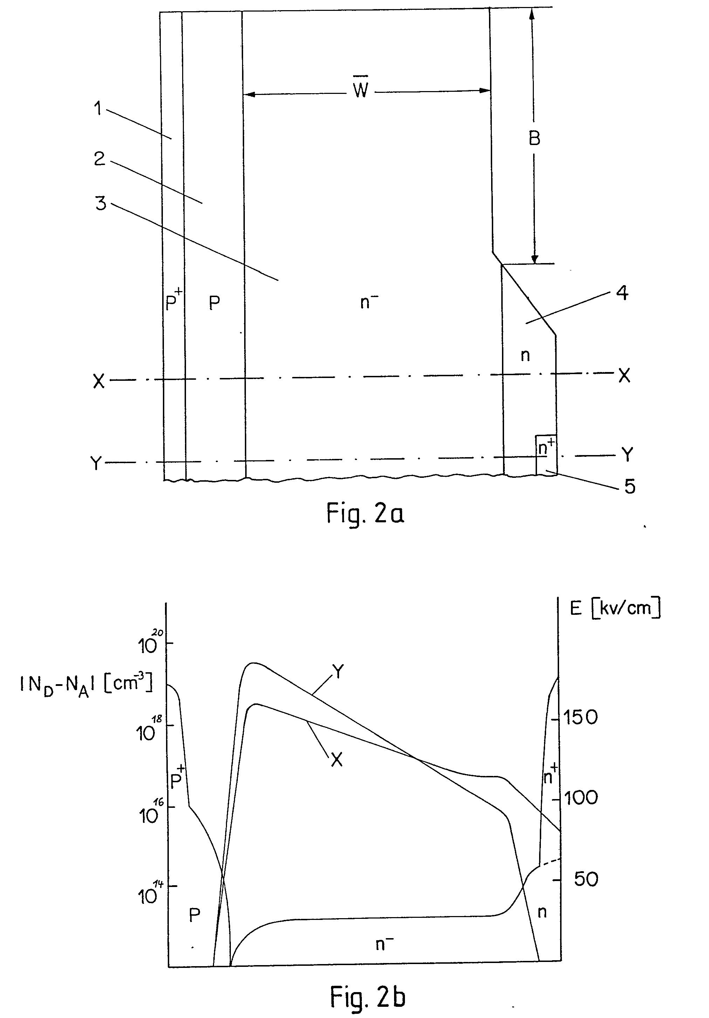

In Fig. 2a ist eine erfindungsgemässe Diode mit einer pn$^-$-n- Struktur dargestellt. Die Bezugszeichen haben dieselbe Bedeutung wie in Fig. 1a. Die Entfernung der n$^-$-Zone 3 von der kathodenseitigen Oberfläche beträgt 30 µm. Die Donatorkonzentration der Stoppschicht 4 weist $6 \cdot 10^{14}$ Atome/cm$^3$ auf. Die Breite B am Rand, auf dem die Stoppschicht 4 vollständig abgetragen ist, entspricht der Weite $\overline{W}$ der n$^-$-Zone 3.

In Fig. 2b ist der Verlauf der Dotierung und der elektrischen Feldstärke bei einer Sperrspannung von 3600 V aufgetragen. Die Bezugszeichen sind Fig. 1 entsprechend. Die Kurven X und Y der elektrischen Feldstärke E entsprechen den Schnitten X–X und Y–Y in Fig. 2a.

Für Thyristoren muss die Stoppschicht im Bereich des p$^+$-Emitters eine wesentlich höhere Gesamtmenge dotierter Fremdatome aufweisen als durch die Formel (1) gefordert wird. Dies bedeutet, dass die Stoppschicht dort wie üblich dimensioniert ist, z.B. 40 µm dick ist und eine Dotierung von $2 \cdot 10^{16}$ Atome/cm$^3$ aufweist.

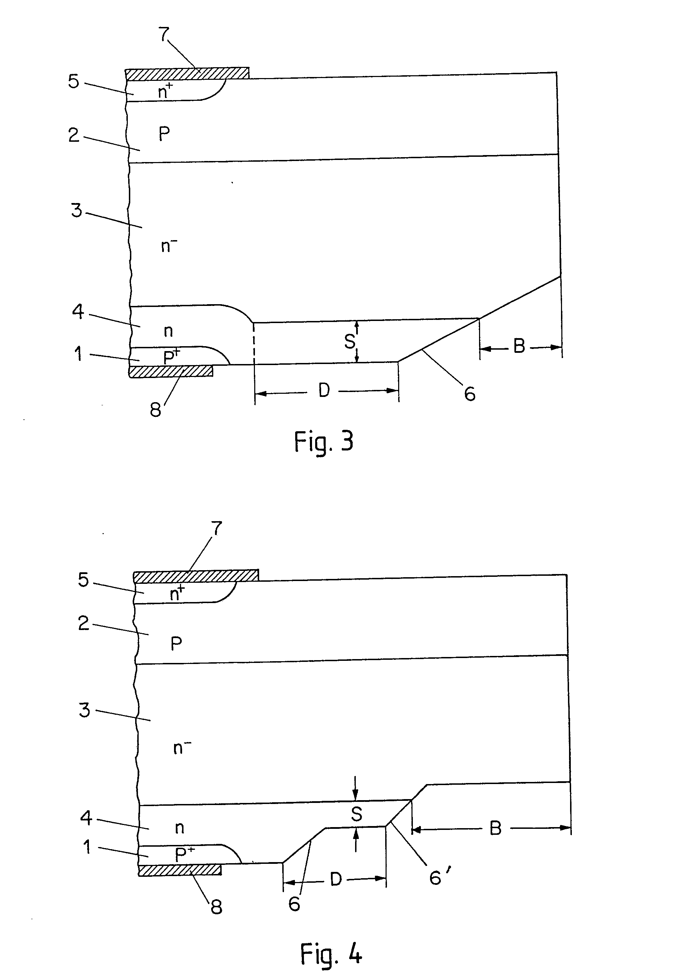

In den Figuren 3 und 4 sind zwei Möglichkeiten der Ausgestaltung bei einem asymmetrischen Thyristor dargestellt. Die Bezeichnungen in der Fig. 3 und 4 sind identisch mit denen in Fig. 1a. Die Dotierungsprofile ausserhalb des Bereiches des p$^+$-Emitters entsprechen wieder denen nach Fig. 1b und 2b. Zusätzlich sind noch eine Kathodenmetallisierung 7 und eine Anodenmetallisierung 8 angebracht.

Bei der ersten Variante gemäss Fig. 3 sind zwei unterschiedliche Stoppschichten 4 vorgesehen, bzw. eine Stoppschicht mit Bereichen unterschiedlicher Donatorkonzentration. Am äusseren Randbereich, etwa der Breite D, entspricht die Donatorkonzentration der Stoppschicht der Formel (1). Im Bereich des p$^+$-Emitters ist die Donatorenkonzentration erhöht.

Bei der zweiten Variante gemäss Fig. 4 ist nur die für den Thyristor erforderliche höher dotierte Stoppschicht 4 eindiffundiert. Im Randbereich ist diese Stoppschicht über eine Ausnehmung 6 und eine zusätzliche Ausnehmung 6' stufenweise so weit abgetragen, dass sich die Raumladungszone dort gerade bis zur anodenseitigen Oberfläche erstreckt. Damit wird die gleiche Wirkung erzielt wie bei der Ausführung gemäss Fig. 3.

Zusammenfassend ist nochmals festzuhalten, dass die erfindungsgemässe Idee im Kern darin besteht, bei nur in einer Polarität sperrenden Halbleiterbauelementen wie Dioden, rückwärts leitenden und asymmetrischen Thyristoren mit einer pn$^-$-n-Schichtenfolge das als Stoppschicht wirkende n-Gebiet nach der Formel (1) zu dotieren und am Rand geeignet zu konturieren. Im Gegensatz zum Stand der Technik liegt diese Randkonturierung also nicht am sperrenden pn-Übergang, sondern auf der von diesem entfernten Seite der n$^-$-n-Schichtenfolge.

## Patentansprüche

1. Halbleiterbauelement

– mit einem anodenseitigen hochdotierten p$^+$-Gebiet (1) und

– einem kathodenseitigen hochdotierten n$^+$-Gebiet (5),

– zwischen denen ein niedrigdotiertes n$^-$-Gebiet (3) und ein n-Stoppgebiet (4) liegen, wobei

– das n-Stoppgebiet (4) höher als das n$^-$-Gebiet (3) aber geringer als das n$^+$-Gebiet (5) dotiert ist und an das n$^-$-Gebiet (3) angrenzt, und

– mit einer Ausnehmung (6) am Rand des n-Stoppgebietes (4),

dadurch gekennzeichnet, dass

— die Dicke S des Stoppgebietes (4) und die Gesamtmenge an Donatoren zumindest am Rand des n-Stoppgebietes (4) so gewählt ist, dass sie der Gleichung

$$\frac{e}{\varepsilon} \int_0^S N_D(x)\,dx = k\,E_n$$

genügt, mit

e = Elementarladung, $\varepsilon$ = Dielektrizitätskonstante des Halbleiters, $N_D$ = Donatorkonzentration im n-Stoppgebiet (4) in $cm^{-3}$, x = Wegkoordinate in cm, k = Konstante, für die gilt: $0,8 \leqslant k \leqslant 1,0$, $E_n$ = Feldstärke am Übergang von $n^-$-Gebiet zum n-Stoppgebiet bei Durchbruchspannung des Bauelementes.

2. Halbleiterbauelement nach Anspruch 1, dadurch gekennzeichnet, dass für die Ausnehmung (6) gilt:

$$B \geqslant W \text{ und } S \leqslant T \leqslant W/2$$

mit B = Breite der Ausnehmung, in der die Stoppschicht des n-Stoppgebietes (4) vollständig abgetragen ist,

W = Breite der Raumladungszone des Halbleiterbauelementes bei maximaler Spannung,

T = maximale Tiefe der Ausnehmung (6) von der Ebene der angrenzenden endseitigen Oberfläche des Halbleiterbauelementes.

3. Halbleiterbauelement nach Anspruch 2, dadurch gekennzeichnet, dass

— das n-Stoppgebiet (4) kathodenseitig zum niedrigdotierten $n^-$-Gebiet (3) angeordnet ist,

— das hochdotierte $n^+$-Gebiet (5) an der kathodenseitigen Oberfläche des Halbleiterbauelementes in das n-Stoppgebiet (4) eingebettet ist,

— zwischen dem Rand des $n^+$-Gebietes (5) und der Ausnehmung (6) ein Abstand D besteht, in dem das Stoppgebiet (4) erhalten bleibt, und

— $D \geqslant W$ ist.

4. Halbleiterbauelement nach Anspruch 2, dadurch gekennzeichnet, dass

— das n-Stoppgebiet (4) anodenseitig zum niedrigdotierten $n^-$-Gebiet (3) angeordnet ist,

— zwischen dem kathodenseitigen $n^+$-Gebiet (5) und dem $n^-$-Gebiet (3) ein niedrigdotiertes p-Gebiet (2) vorgesehen ist,

— das hochdotierte $p^+$-Gebiet (1) an der anodenseitigen Oberfläche des Halbleiterbauelementes in das n-Stoppgebiet (4) eingebettet ist, und

— die Donatorenkonzentration des n-Stoppgebietes (4) nur am Rand des n-Stoppgebietes (4) die Integralgleichung

$$\frac{e}{\varepsilon} \int_0^S N_D(x)\,dx = k\,E_n$$

erfüllt und im Bereich des $p^+$-Gebiets (1) demgegenüber erhöht ist.

5. Halbleiterbauelement nach Anspruch 2, dadurch gekennzeichnet, dass

— das n-Stoppgebiet (4) anodenseitig zum niedrigdotierten $n^-$-Gebiet angeordnet ist,

— zwischen dem kathodenseitigen $n^+$-Gebiet (5) und dem $n^-$-Gebiet (3) ein niedrigdotiertes p-Gebiet (2) vorgesehen ist,

— das hochdotierte $p^+$-Gebiet (1) an der anodenseitigen Oberfläche des Halbleiterbauelementes in das n-Stoppgebiet (4) eingebettet ist,

— die Donatorenkonzentration des n-Stoppgebietes (4) gegenüber dem durch die Integralgleichung

$$\frac{e}{\varepsilon} \int_0^S N_D(x)\,dx = k\,E_n$$

gegebenen Wert erhöht ist, und

— im Randbereich des n-Stoppgebietes (4) eine zusätzliche Ausnehmung (6') vorgesehen ist, welche die Dicke (S) des n-Stoppgebietes im Übergangsbereich zur $n^-$-Schicht (3) soweit reduziert, dass die Integralgleichung dort trotz der erhöhten Donatorenkonzentration erfüllt ist.

## Revendications

1. Composant semi-conducteur

— avec un domaine $p^+$ (1) fortement dopé situé du côté de l'anode et

— un domaine $n^+$ (5) fortement dopé situé du côté de la cathode,

— entre lesquels se trouve un domaine $n^-$ (3) faiblement dopé et un domaine n d'arrêt (4), dans lequel

— le domaine n d'arrêt (4) est dopé plus fortement que le domaine $n^-$ (3) mais moins fortement que le domaine $n^+$ (5) et est adjacent au domaine $n^-$ (3), et

— avec une cavité (6) au bord du domaine n d'arrêt (4),

caractérisé en ce que

— l'épaisseur S du domaine d'arrêt (4) et la quantité totale de donneur au moins au bord du domaine n d'arrêt (4) sont choisies de telle façon qu'elle satisfait la relation

$$\frac{e}{\varepsilon} \int_0^S N_D(x)\,dx = k\,E_n$$

avec

e = charge élémentaire

$\varepsilon$ = constante diélectrique du matériau semi-conducteur

$N_D$ = concentration de donneur dans le domaine n d'arrêt (4), en $cm^{-3}$

x = coordonnée de distance, en cm

k = constante, soumise à la condition $0,8 \leqslant k \leqslant 1,0$

$E_n$ = intensité du champ à la jonction du domaine $n^-$ et du domaine n pour la tension de claquage du composant.

2. Composant semi-conducteur suivant la revendication 1, caractérisé en ce que, pour la cavité (6), on a les relations:

$$B \geqslant W \text{ et } S \leqslant T \leqslant W/2$$

avec B = largeur de la cavité, sur laquelle la couche n d'arrêt (4) est entièrement enlevée, W = largeur de la zone de charge d'espace du composant semi-conducteur pour la tension maximale,

T = profondeur maximale de la cavité (6) à partir du plan de la surface d'extrémité adjacente du composant semi-conducteur.

3. Composant semi-conducteur suivant la revendication 2, caractérisé en ce que:

– le domaine n d'arrêt (4) est disposé du côté cathodique par rapport au domaine n⁻ (3) faiblement dopé,

– le domaine n⁺ (5) fortement dopé est, dans la surface du côté cathodique du composant semi-conducteur, logé dans le domaine n d'arrêt (4),

– entre le bord du domaine n⁺ (5) et la cavité (6), il existe une distance D dans laquelle est formé le domaine d'arrêt (4), et

– on a: D ⩾ W.

4. Composant semi-conducteur suivant la revendication 2, caractérisé en ce que:

– le domaine n d'arrêt (4) est disposé du côté anodique par rapport au domaine n⁻ (3) faiblement dopé,

– il est prévu un domaine p (2) faiblement dopé entre le domaine n⁺ (5) cathodique et le domaine n⁻ (3),

– le domaine p⁺ (1) fortement dopé est, dans la surface du côté anodique du composant semi-conducteur, logé dans le domaine n d'arrêt (4), et

– la concentration de donneur du domaine n d'arrêt (4) satisfait la relation intégrale

$$\frac{e}{\varepsilon} \int_0^S N_D(x)\,dx = k\,E_n$$

uniquement au bord du domaine n d'arrêt (4) et est accrue par rapport à celui-ci dans la région du domaine p⁺ (1).

5. Composant semi-conducteur suivant la revendication 2, caractérisé en ce que:

– le domaine n d'arrêt (4) est disposé du côté anodique par rapport au domaine n⁻ faiblement dopé,

– il est prévu un domaine p (2) faiblement dopé entre le domaine n⁺ (5) cathodique et le domaine n⁻ (3),

– le domaine p⁺ (1) fortement dopé est, dans la surface du côté anodique du composant semi-conducteur, logé dans le domaine n d'arrêt (4),

– la concentration de donneur du domaine n d'arrêt (4) est accrue par rapport à la valeur donnée par la relation intégrale

$$\frac{e}{\varepsilon} \int_0^S N_D(x)\,dx = k\,E_n$$

– et, dans la région du bord du domaine n d'arrêt (4), il est prévu une cavité supplémentaire (6'), qui diminue l'épaisseur S du domaine n d'arrêt dans la région de la jonction avec la couche n⁻ (3), à un point tel que la relation intégrale est satisfaite à cet endroit, malgré l'augmentation de la concentration de donneur.

**Claims**

1. Semiconductor component
– with an anode-side, highly doped p⁺ region (1) and
– a cathode-side, highly doped n⁺ region (5),
– between which are situated a sparingly doped n⁻ region (3) and an n barrier region (4), the n barrier
– region (4) being more highly doped than the n⁻ region (3) but more sparingly doped than the n⁺ region (5) and adjoining the n⁻region(3), and
– with a recess (6) at the edge of the n barrier region (4), characterized in that
– the thickness S of the barrier region (4) and the total quantity of donors, at least at the edge of the n barrier region (4), are chosen so that they satisfy the equation

$$\frac{e}{\varepsilon} \int_0^S N_D(x)\,dx = k\,E_n$$

where
e = electronic charge, = dielectric constant of the semiconductor, $N_D$ = donor concentration in the n barrier region (4) in cm⁻³, x = distance coordinate in cm, k = constant for which $0.8 < k < 1.0$ is valid, $E_n$ = field strength at the junction between the n⁻ region and the n barrier region at the breakdown voltage of the component.

2. Semiconductor component according to claim 1, characterized in that the following is valid for the recess (6):

$$B \geqslant W \text{ and } S \leqslant T \leqslant W/2$$

where
B = width of the recess in which the barrier layer of the n barrier region (4) is completely removed,
W = width of the space charge zone of the semiconductor component at maximum voltage,
T = maximum depth of the recess (6) from the plane of the adjoining end surface of the semiconductor component.

3. Semiconductor component according to claim 2, characterized in that
– the n barrier region (4) on the cathode side is disposed next to the sparingly doped n⁻ region (3),
– the highly doped n⁺ region (5) at the cathode-side surface of the semiconductor component is embedded in the n barrier region (4),
– between the edge of the n⁺ region (5) and the recess' (6) there is a distance D in which the barrier region (4) remains intact, and
– D ⩾ W.

4. Semiconductor component according to claim 2, characterized in that

— the n barrier region (4) on the anode side is disposed next to the sparingly doped n⁻ region (3),

— a sparingly doped p region (2) is provided between the cathode-side n⁺ region (5) and the n⁻ region (3),

— the highly doped p⁺ region (1) at the anode-side surface of the semiconductor component is embedded in the n barrier region (4), and

— the donor concentration of the n barrier region (4) fulfils the integral equation S

$$\frac{e}{\varepsilon} \int_0^S N_D(x)\,dx = k\,E_n$$

only at the edge of the n barrier region (4) and, on the other hand, is increased in the region of the p⁺ region (1).

5. Semiconductor component according to claim 2, characterized in that

— the n barrier region (4) on the anode side is disposed next to the sparingly doped n⁻ region,

— a sparingly doped p region (2) is provided between the cathode-side n⁺ region (5) and the n⁻ region (3),

— the highly doped p⁺ region (1) at the anode-side surface of the semiconductor component is embedded in the n barrier region (4),

— the donor concentration of the n barrier region (4) is increased compared with the value given by the integral equation

$$\frac{e}{\varepsilon} \int_0^S N_D(x)\,dx = k\,E_n$$

and

— in the edge region of the n barrier region (4) an additional recess (6) is provided which reduces the thickness (S) of the n barrier region in the region of the junction with the n⁻ layer (3) to such an extent that the integral equation is fulfilled at that point despite the increased donor concentration.

Fig. 1a

Fig. 1b

Fig. 2a

Fig. 2b

0 144 876

Fig. 3

Fig. 4